# EUROPÄISCHE PATENTSCHRIFT

(11) **EP 1 505 664 B1**
(45) Veröffentlichungstag und Bekanntmachung des Hinweises auf die Patenterteilung: **23.09.2015**
(21) Anmeldenummer: 04017458.3
(22) Anmeldetag: 23.07.2004
(51) Int. Cl.: H01B 1/12, H01L 51/44, H01L 51/52

(54) **Transparente Elektrode für elektro-optische Aufbauten**
Transparent electrode for optoelectronic devices
Electrode transparent pour des dispositifs électro optique

(30) Priorität: 05.08.2003 DE 10335727
(43) Veröffentlichungstag der Anmeldung: 09.02.2005
(73) Patentinhaber: Heraeus Deutschland GmbH & Co. KG, 63450 Hanau (DE)
(72) Erfinder: Elschner, Andreas Dr., 45479 Mülheim (DE); Merker, Udo, Dr., 50679 Köln (DE); Sautter, Armin, Dr., Shanghai 200021 (CN)
(74) Vertreter: Herzog, Fiesser & Partner Patentanwälte PartG mbB

(56) Entgegenhaltungen:
- WO-A-02/080627
- WO-A-03/054981
- MULFORT K L ET AL: "Preparation of surface initiated polystyrenesulfonate films and PEDOT doped by the films" POLYMER, ELSEVIER SCIENCE PUBLISHERS B.V, GB, Bd. 44, Nr. 11, 1. Mai 2003 (2003-05-01), Seiten 3185-3192, XP004423188 ISSN: 0032-3861
- ZOTTI ET AL: "Mono- and multilayers of oligoethylene oxide-modified poly(3,4-ethylenedioxythiophene) on ITO and glass surfaces" CHEMISTRY OF MATERIALS, AMERICAN CHEMICAL SOCIETY, WASHINGTON, US, Bd. 15, 20. Mai 2003 (2003-05-20), Seiten 2222-28, XP002267044 ISSN: 0897-4756
- ZHANG F ET AL: "POLYMER PHOTOVOLTAIC CELLS WITH CONDUCTING POLYMER ANODES" ADVANCED MATERIALS, WILEY VCH, WEINHEIM, DE, Bd. 14, Nr. 9, 3. Mai 2002 (2002-05-03), Seiten 662-665, XP001129768 ISSN: 0935-9648
- LEE K Y ET AL: "Thickness effects of conducting polymer as an ITO replacement on electroluminescent devices" THIN SOLID FILMS, ELSEVIER-SEQUOIA S.A. LAUSANNE, CH, Bd. 363, Nr. 1-2, 1. März 2000 (2000-03-01), Seiten 225-228, XP004189312 ISSN: 0040-6090

## Beschreibung

Die Erfindung betrifft transparente Elektroden aus leitfähigen Polymeren, deren Herstellung und deren Verwendung in elektrooptischen Aufbauten.

Displays auf Basis organischer Leuchtdioden (OLEDs) sind auf Grund ihrer besonderen Eigenschaften eine Alternative zu der etablierten Technologie der Flüssigkristalle (LCD). Insbesondere in Anwendungen portabler, vom Stromfestnetz abgekoppelter Geräte, wie z.B. Mobiltelephone, Pager und Spielzeug, hat diese neue Technologie Vorteile.

Als Vorteile von OLEDs gelten u.a. die extrem flache Bauweise, die Eigenschaft selbst Licht zu erzeugen, d.h. ohne zusätzliche Lichtquelle auszukommen wie bei Flüssigkristallanzeigen (LCDs), die hohe Lichtausbeute und die Blickwinkelfreiheit.

Neben Displays können OLEDs aber auch zum Zweck der Beleuchtung, wie z.B. in Flächenstrahlern, Verwendung finden. Aufgrund ihrer extrem flachen Bauweise lassen sich hiermit sehr dünne Beleuchtungselemente konstruieren, was bisher nicht möglich war. Die Lichtausbeuten von OLEDs übertreffen mittlerweile die von thermischen Strahlern, wie z.B. Glühbirnen und das Emissionsspektrum kann durch geeignete Wahl der Emittermaterialien im Prinzip beliebig variiert werden.

Sowohl OLED-Displays, als auch OLED-Beleuchtungselemente sind nicht auf eine flache starre Bauweise beschränkt. Ebenso lassen sich flexible oder beliebig gekrümmte Anordnungen realisieren, aufgrund der Flexiblität der organischen Funktionsschichten.

Ein Vorteil organischer Leuchtdioden liegt im einfachen Aufbau. Üblicherweise sieht dieser Aufbau folgendermaßen aus: Auf einem transparenten Träger, z.B. Glas oder Kunststofffolie, wird eine transparente Elektrode aufgebracht. Darauf kommt mindestens eine organische Schicht (Emitterschicht) oder ein Stapel nacheinander aufgebrachter organischer Schichten. Zum Schluss wird eine Metall-Elektrode aufgebracht.

Der prinzipiell gleiche Aufbau liegt organischen Solarzellen (OCSs) zugrunde (Halls et al., *Nature* **1995**, 376, 498) nur dass hier in der Umkehrung Licht in elektrische Energie konvertiert wird.

Der wirtschaftliche Erfolg dieser neuen elektro-optischen Aufbauten wird neben der Erfüllung der technischen Anforderungen wesentlich von den Herstellungskosten abhängen. Vereinfachte Prozessschritte, die zu einer Reduzierung des Herstellungsaufwandes und der Herstellungskosten führen, sind daher von großer Bedeutung.

Als transparente Elektroden in OLEDs oder OSCs werden bisher üblicherweise TCO-Schichten (Transparent Conducting Oxides), wie Indium-Zinnoxid (ITO) oder Antimon-Zinnoxid (ATO) oder dünne Metallschichten verwendet. Die Abscheidung dieser anorganischen Schichten erfolgt durch Sputtern, reaktives Oberflächenzerstäubung (Sputtern) oder thermisches Verdampfen des organischen Materials im Vakuum und ist damit aufwendig und kostenintensiv.

ITO-Schichten sind bei der Herstellung von OLEDs oder OSCs ein wesentlicher Kostenfaktor. ITO-Schichten werden aufgrund ihrer hohen elektrischen Leitfähigkeit bei gleichzeitig hoher Transparenz eingesetzt. Die erheblichen Nachteile von ITO sind jedoch:
a) ITO kann nur in einem aufwendigen, kostenintensiven Vakuumprozess durch (reaktives Sputtern) abgeschieden werden.
b) Beim Abscheideprozess sind Temperaturen von T > 400°C erforderlich, wenn hohe Leitfähigkeiten erzielt werden sollen. Insbesondere die für flexible Displays wichtigen Polymersubstrate halten diesen Temperaturen nicht stand.
c) ITO ist spröde und bildet bei Verformung Risse.
d) Das Metall Indium ist ein begrenzt produzierter Rohstoff und Versorgungsengpässe werden bei weiter steigendem Verbrauch vorhergesagt.
e) Die umweltgerechte Entsorgung von elektrooptischen Aufbauten, die das Schwermetall Indium enthalten, ist ein bisher ungelöstes Problem.

ITO-Schichten werden trotz dieser Nachteile wegen ihres günstigen Verhältnisses von elektrischen Leitfähigkeit zu optischer Absorption und vor allem mangels geeigneter Alternativen weiterhin verwendet. Eine hohe elektrische Leitfähigkeit ist notwendig, um den Spannungsabfall über die transparente Elektrode von stromgetriebenen Aufbauten niedrig zu halten.

In der Vergangenheit wurden Alternativen zu ITO als Elektrodenmaterialien diskutiert, jedoch wurde bisher keine Alternative gefunden, die die vorangehend beschriebenen Nachteile nicht aufweist und gleichzeitig in elektrooptischen Aufbauten vergleichbar gute Eigenschaften liefert.

So wurde beispielsweise ein Komplex aus Polyethylendioxythiophen und Polystyrolsulfonsäure, in der Fachwelt auch kurz als PEDT/PSS oder PEDT:PSS bezeichnet, als Ersatz für ITO als Elektrodenmaterial vorgeschlagen (EP-A 686 662, Inganäs et al. Adv. Mater. 2002, 14, 662 - 665; Lee et al. Thin Solid Films 2000, 363, 225 - 228; Kim et al. Appl. Phys. Lett. 2002, Vol. 80, No. 20, 3844 - 3846). Der Oberflächenwiderstand von PEDT:PSS-Schichten hängt vom Mischungsverhältnis PEDT zu PSS und von der Zugabe von Additiven ab. Elektroden aus einer reinen PEDT/PSS-Schicht sind aufgrund der zu niedrigen Leitfähigkeit als Ersatz für ITO-Elektroden ungeeignet. Durch Zugabe von Additiven wie N-Methylpyrolidon, Sorbit oder Glycerol kann zwar die Leitfähigkeit erhöht werden, jedoch sind diese Schichten als Elektrodenmaterialien aufgrund der prozessbedingt gröberen Teilchen und der damit verbundenen höheren Kurzschlusswahrscheinlichkeit für OLEDs und OSCs ebenfalls ungeeignet.

Auch die Verwendung von in-Situ polymerisierten Schichten, insbesondere von in-Situ-polymerisiertem PEDT, in der Fachwelt auch kurz als in-situ-PEDT bezeichnet, als Ersatz für ITO für transparente Elektroden ist beschrieben (WO-A 96/08047), jedoch weist in-Situ-PEDT für Anwendungen in OLEDs den wesentlichen Nachteil auf, dass die hiermit erzielbare Lichtausbeute sehr niedrig ist.

K. Y. Lee et al. (Thin Solid Films; Vol. 363 (2000); Seiten 225-228) offenbaren eine organische elektrolumineszierenden Zelle mit der Struktur ITO/CPP400-Paste/TPD/Alq₃/Li:Al (ITO = Indiumzinn-oxid; CPP400-Paste = PEDOT/PSS; TPD =Triphenyldiamin-Derivat; Alq₃ = tris(8-hydroxycholin)-aluminium(III)).

K. L. Mulfort et al. (Polymer; Vol. 44 (2003); Seiten 3185-3192 offenbaren ein Verfahren zur Herstellung einer PEDOT/PSS-Schicht auf einem Substrat, wobei Monomereinheiten auf einem PSS-Film durch Zugabe von FeCl₃ polymerisiert werden.

Es bestand daher weiterhin Bedarf an transparenten Elektroden, die als gleichwertiger Ersatz für ITO-Elektroden in elektrischen bzw, elektrooptischen Aufbauten verwendet werden können.

Aufgabe der vorliegenden Erfindung war es somit, transparente Elektroden herzustellen, die die herkömmlichen ITO-Elektroden ersetzen können, ohne jedoch die vorangehend aufgeführten Nachteile aufzuweisen.

Überraschend wurde gefunden, dass eine Elektrode enthaltend eine Schicht aus einem leitfähigen Polymer, auf die eine Schicht enthaltend wenigstens ein polymeres Anion und wenigstens ein Polythiophen aufgebracht ist, diese Anforderungen erfüllt.

Gegenstand der vorliegenden Erfindung ist eine transparente Elektrode, dadurch gekennzeichnet, dass sie eine Schicht enthaltend wenigstens ein leitfähiges Polymer enthält, auf die eine zweite Schicht enthaltend wenigstens ein polymeres Anion und wenigstens ein gegebenenfalls substituiertes Polyanilin und/oder wenigstens ein Polythiophen mit wiederkehrenden Einheiten der allgemeinen Formal (I) aufgebracht ist, 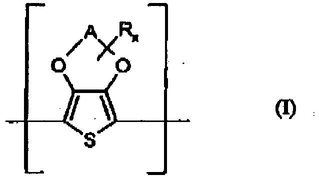 worin
- A: für einen gegebenenfalls substituierten C₁-C₅-Alkylenrest, bevorzugt für einen gegebenenfalls substituierten C₂-C₃-Alkylenrest, steht,
- R: für einen linearen oder verzweigten, gegebenenfalls substituierten C₁-C₁₈-Alkylrest, bevorzugt linearen oder verzweigten, gegebenenfalls substituierten C₁-C₁₄-Alkylrest, einen gegebenenfalls substituierten C₅-C₁₂-Cycloalkylrest, einen gegebenenfalls substituierten C₆- C₁₄-Arylrest, einen gegebenenfalls substituierten C₇-C₁₈-Aralkylrest, einen gegebenenfalls substituierten C₁-C₄-Hydroxyalkylrest, bevorzugt gegebenenfalls substituierten C₁-C₂-Hydroxyalkylrest, oder einen Hydroxylrest steht,
- x: für eine ganze Zahl von 0 bis 8 steht, bevorzugt von 0 bis 6, besonders bevorzugt für 0 oder 1 steht und

für den Fall, dass mehrere Reste R an A gebunden sind, diese gleich oder unterschiedlich sein können.

Die erste Schicht enthaltend das leitfähige Polymer wird auch elektrisch leitfähige Schicht genannt.

Die allgemeine Formel (I) ist so zu verstehen, dass x Substituenten R an den Alkylenrest A gebunden sein können.

Bevorzugt ist auf die Schicht enthaltend wenigstens ein leitfähiges Polymer, eine Schicht enthaltend wenigstens ein polymeres Anion und wenigstens ein Polythiophen mit wiederkehrenden Einheiten der allgemeinen Formel (I) aufgebracht.

Bevorzugte leitfähige Polymere sind gegebenenfalls substituierte Polythiophene, Polypyrrole oder Polyaniline, besonders bevorzugt sind Polythiophene mit wiederkehrenden Einheiten der allgemeinen Formel (I).

In bevorzugten Ausführungsformen sind Polythiophene mit wiederkehrenden Einheiten der allgemeinen Formel (I) solche mit wiederkehrenden Einheiten der allgemeinen Formel (Ia), 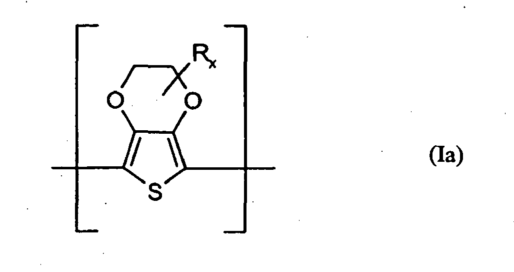 worin
- R und x: die oben genannte Bedeutung haben.

In weiteren bevorzugten Ausführungsformen sind die Polythiophene solche mit wiederkehrenden Einheiten der allgemeinen Formel (Iaa)

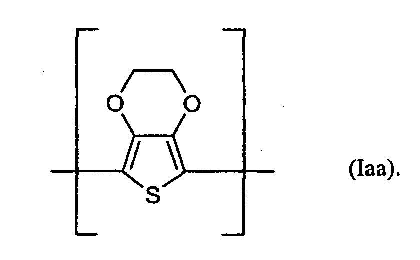

Unter dem Präfix Poly- ist im Rahmen der Erfindung zu verstehen, dass mehr als eine gleiche oder verschiedene wiederkehrende Einheit im Polymeren bzw. Polythiophen enthalten ist. Die Polythiophene enthalten insgesamt n wiederkehrende Einheiten der allgemeinen Formel (I), wobei n insbesondere eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene mit jeweils gleichen wiederkehrenden Einheiten der allgemeinen Formel (I).

An den Endgruppen tragen die Polythiophene bevorzugt jeweils H.

In einer besonders bevorzugten Ausführungsform ist das Polythiophen mit wiederkehrenden Einheiten der allgemeinen Formel (I) Poly(3,4-ethylendioxythiophen), d.h. ein Homopolythiophen aus wiederkehrenden Einheiten der Formel (Iaa).

C₁-C₅-Alkylenreste A sind im Rahmen der Erfindung: Methylen, Ethylen, n-Propylen, n-Butylen oder n-Pentylen. C₁-C₁₈-Alkyl steht im Rahmen der Erfindung für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste, wie Cyclopentyl, Cyclohexyl, Cycloheptyl, Cyclooctyl, Cyclononyl oder Cyclodecyl, C₅-C₁₄-Aryl für C₅-C₁₄-Arylreste wie Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Als gegebenenfalls weitere Substituenten der C₁-C₅-Alkylenreste A kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Bevorzugte polymere Anionen sind beispielsweise Anionen polymerer Carbonsäuren, wie Polyacrylsäuren, Polymethacrylsäure oder Polymaleinsäuren, oder polymerer Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein.

Besonders bevorzugt als polymeres Anion ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Die leitfähigen Polymere bzw. Polythiophene können neutral oder kationisch sein. In bevorzugten Ausführungsformen sind sie kationisch, wobei sich "kationisch" nur auf die Ladungen bezieht, die auf der Polymer- bzw. Polythiophenhauptkette sitzen. Je nach Substituent an den Resten R können die Polymere bzw. Polythiophene positive und negative Ladungen in der Struktureinheit tragen, wobei sich die positiven Ladungen auf der Polymer- bzw. Polythiophenhauptkette und die negativen Ladungen gegebenenfalls an den durch Sulfonat- oder Carboxylatgruppen substituierten Resten R befinden. Dabei können die positiven Ladungen der Polymer- bzw. Polythiophenhauptkette zum Teil oder vollständig durch die gegebenenfalls vorhandenen anionischen Gruppen an den Resten R abgesättigt werden. Insgesamt betrachtet können die Polymere bzw. Polythiophene in diesen Fällen kationisch, neutral oder sogar anionisch sein. Dennoch werden sie im Rahmen der Erfindung alle als kationische Polymere bzw. Polythiophene betrachtet, da die positiven Ladungen auf der Polymer- bzw. Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polymers bzw. Polythiophens ist.

Zur Kompensation der positiven Ladung, soweit dies nicht bereits durch die gegebenenfalls Sulfonat- oder Carboxylat-substituierten und somit negativ geladenen Reste R erfolgt, benötigen die kationischen Polymere bzw. Polythiophene Anionen als Gegenionen.

Als Gegenionen kommen monomere oder polymere Anionen, letztere im Folgenden auch als Polyanionen bezeichnet, in Frage.

Als polymere Anionen kommen die vorangehend bereits aufgeführten in Frage. Als monomere Anionen dienen beispielsweise solche von C₁-C₂₀-Alkansulfonsäuren, wie der Methan-, Ethan-, Propan-, Butan- oder höheren Sulfonsäuren, wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen C₁-C₂₀-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch C₁-C₂₀-Alkylgruppen substituierten Sulfonsäuren wie der Benzolsulfonsäure, o-Toluolsulfonsäure, p-Toluolsulfonsäure oder der Dodecylbenzolsulfonsäure und von Cycloalkansulfonsäuren wie Camphersulfonsäure oder Tetrafluoroborate, Hexafluorophosphate, Perchlorate, Hexafluoroantimonate, Hexafluoroarsenate oder Hexachloroantimonate.

Besonders bevorzugt sind die Anionen der p-Toluolsulfonsäure, Methansulfonsäure oder Camphersulfonsäure.

Kationische Polythiophene, die zur Ladungskompensation Anionen als Gegenionen enthalten, werden in der Fachwelt auch oft als Polythiophen/(Poly-)Anion-Komplexe bezeichnet.

In der Schicht enthaltend wenigstens ein polymeres Anion und wenigstens ein Polythiophen mit wiederkehrenden Einheiten der allgemeinen Formel (I) kann das polymere Anion als Gegenion fungieren. Es können jedoch auch zusätzliche Gegenionen in der Schicht enthalten sein. Bevorzugt dient jedoch in dieser Schicht das polymere Anion als Gegenion.

Polymere(s) Anion(en) und Polythiophen(e) können in der Schicht in einem Gewichtsverhältnis von 0,5:1 bis 50:1, bevorzugt von 1:1 bis 30:1, besonders bevorzugt 2:1 bis 20:1 enthalten sein. Das Gewicht der Polythiophene entspricht hierbei der Einwaage der eingesetzten Monomere unter Annahme, dass bei der Polymerisation vollständiger Umsatz erfolgt.

In bevorzugten Ausführungsformen enthält die transparente Elektrode eine Schicht aus einem leitfähigen Polymer, einem Polythiophen, Polypyrrol oder Polyanilin, bevorzugt einem Polythiophen mit wiederkehrenden Einheiten der allgemeinen Formel (I), in der R, A und x die oben genannte Bedeutung haben, auf die eine zweite Schicht aus einem polymeren Anion und einem Polythiophen mit wiederkehrenden Einheiten der allgemeinen Formel (I) aufgebracht ist.

In einer ganz besonders bevorzugten Ausführungsform enthält die transparente Elektrode eine Schicht aus Poly(3,4-ethylendioxythiophen) auf die eine Schicht aus Polystyrolsulfonsäure und Poly(3,4-ethylendioxythiophen), letzteres in Fachkreisen auch als PEDT/PSS oder PEDT:PSS bezeichnet, aufgebracht ist.

Die erfindungsgemäße transparente Elektrode kann auf ein Substrat aufgebracht sein. Bei einem solchen Substrat kann es sich beispielsweise um Glas, Dünnstglas (flexibles Glas) oder Kunststoffe handeln.

Besonders geeignete Kunststoffe für das Substrat sind: Polycarbonate, Polyester wie z.B. PET und PEN (Polyethylenterephthalat bzw. Polyethylennaphthalindicarboxylat), Copolycarbonate, Polysulfon, Polyethersulfon (PES), Polyimid, Polyethylen, Polypropylen oder cyclische Polyolefine bzw. cyclische Olefincopolymere (COC), hydrierte Styrolpolymere oder hydrierte Styrolcopolymere.

Geeignete Polymerunterlagen (Substrate) können beispielsweise Folien wie Polyesterfolien, PES-Folien der Firma Sumitomo oder Polycarbonatfolien der Firma Bayer AG (Makrofol®) sein.

Zwischen dem Substrat und der Elektrode kann sich eine Haftvermittlerschicht befinden. Geeignete Haftvermittler sind beispielsweise Silane. Bevorzugt sind Epoxysilane, wie beispielsweise 3-Glycidoxypropyltrimethoxysilan (Silquest® A187, Fa. OSi specialities). Es können auch andere Haftvermittler mit hydrophilen Oberflächeneigenschaften verwendet werden. So wird z.B. eine dünne Schicht aus PEDT:PSS als geeigneter Haftvermittler für PEDT beschrieben (Hohnholz et al., Chem. Commun. 2001, 2444-2445).

Die erfindungsgemäße Elektrode hat gegenüber den eingangs beschriebenen bekannten transparenten ITO-freien Elektroden den Vorteil, dass sie sowohl eine gute Leitfähigkeit als auch eine gute Transmission aufweist.

Bevorzugter Gegenstand der Erfindung ist eine transparente Elektrode mit einem Oberflächenwiderstand der beiden Polymerschichten (erste leitende und zweite Schicht) von kleiner oder gleich 1000 Ω/sq, besonders bevorzugt von kleiner oder gleich 500 Ω/sq, ganz besonders bevorzugt von kleiner oder gleich 300 Ω/sq.

Transparent im Sinne der Erfindung bedeutet transparent für sichtbares Licht.

Weiterhin bevorzugter Gegenstand der Erfindung ist eine transparente Elektrode, die eine Transmission von Y größer oder gleich 25, besonders bevorzugt Y größer oder gleich 50 aufweist. Die Transmission wird bestimmt nach der Meßmethode wie sie in der Vorschrift ASTM D 1003-00 beschrieben ist. Die Transmission wird dann entsprechend ASTM E 308 (Lichtart C, 2* Beobachter) bestimmt.

Auch die Oberflächenrauhigkeit der erfindungsgemäßen Elektrode ist vorteilhafterweise deutlich kleiner als beispielsweise die der aus EP-A 686 662 bekannten Elektroden, so dass die Kurzschlusswahrscheinlichkeit für OLEDs und OSCs mit den erfindungsgemäßen Elektroden reduziert wird.

Beispielsweise können die erfindungsgemäßen Elektroden eine Oberflächenrauhigkeit mit einem Mittenrauhwert Ra von kleiner oder gleich 3 nm, besonders bevorzugt von kleiner oder gleich 1,5 nm aufweisen, ganz besonders bevorzugt von kleiner oder gleich 1 nm aufweisen.

Die erfindungsgemäßen Elektroden können auf einfache Weise hergestellt werden, indem alle Elektrodenschichten aus Lösung nacheinander aufgebracht werden. Auf diese Weise werden aufwändige und kostenintensive Aufdampf- oder Aufsputterverfahren vermieden.

Die Herstellung erfolgt zweckmäßigerweise so, dass die Schicht enthaltend wenigstens ein leitfähiges Polymer aus Vorstufen zur Herstellung leitfähiger Polymere gegebenenfalls in Form von Lösungen direkt in situ auf einem geeigneten Substrat mittels chemischer oxidativer Polymerisation in Gegenwart eines oder mehrerer Oxidationsmittel oder mittels Elektropolymerisation hergestellt wird und auf diese Schicht gegebenenfalls nach Trocknung und Waschen die Schicht enthaltend wenigstens ein polymeres Anion und wenigstens ein Polythiophen mit wiederkehrenden Einheiten der allgemeinen Formel (I) aus einer Dispersion enthaltend wenigstens ein polymeres Anion und wenigstens ein Polythiophen mit wiederkehrenden Einheiten der allgemeinen Formel (I) aufgebracht wird.

Weiterhin Gegenstand der vorliegenden Erfindung ist ein Verfahren zur Herstellung einer transparenten Elektrode, dadurch gekennzeichnet, dass
eine erste Schicht enthaltend wenigstens ein leitfähiges Polymer hergestellt wird, indem auf ein Substrat Vorstufen zur Herstellung leitfähiger Polymere gegebenenfalls in Form von Lösungen aufgebracht werden und chemisch oxidativ in Gegenwart eines oder mehrerer Oxidationsmittel oder elektrochemisch zu den leitfähigen Polymeren polymerisiert werden, und
gegebenenfalls nach Waschen und Trocknung auf diese Schicht eine zweite Schicht enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) 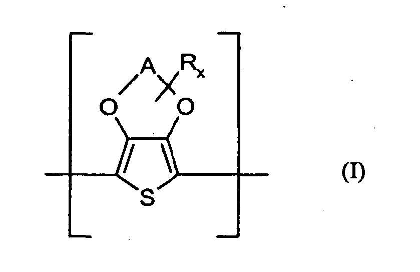 worin
- A, R und x: die oben zu Formel (I) genannte Bedeutung haben,
und durch Aufbringen einer gegebenenfalls lösungsmittelhaltigen Dispersion enthaltend wenigstens ein polymeres Anion und wenigstens ein Polythiophen mit wiederkehrenden Einheiten der allgemeinen Formel (I) auf die elektrisch leitfähige Schicht und anschließendes Verfestigen der Dispersion, gegebenenfalls durch Entfernen des Lösungsmittels oder Vernetzer der Dispersion aufgebracht wird.

Als geeignete Substrate kommen die vorangehend bereits aufgeführten in Frage. Das Substrat kann vor Aufbringen der Schicht enthaltend wenigstens ein leitfähiges Polymer mit einem Haftvermittler behandelt werden. Eine solche Behandlung kann beispielsweise durch Spincoating, Tränkung, Gießen, Auftropfen, Spritzen, Aufsprühen, Aufrakeln, Bestreichen oder Bedrucken, beispielsweise Ink-jet-, Sieb-, Kontakt- oder Tampondrucken erfolgen.

Unter Vorstufen für die Herstellung leitfähiger Polymere, im Folgenden auch als Vorstufen bezeichnet, werden entsprechende Monomere oder deren Derivate verstanden. Es können auch Mischungen von unterschiedlichen Vorstufen verwendet werden. Geeignete monomere Vorstufen sind beispielsweise gegebenenfalls substituierte Thiophene, Pyrrole oder Aniline, bevorzugt gegebenenfalls substituierte Thiophene der allgemeinen Formel (II), 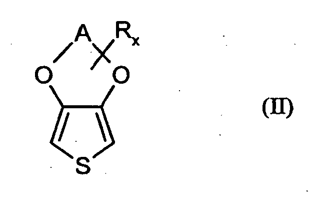 worin
- A, R und x: die oben genannte Bedeutung haben,
besonders bevorzugt gegebenenfalls substituierte 3,4-Alkylendioxythiophene der allgemeinen Formel (IIa)

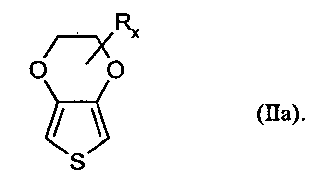

In einer bevorzugten Ausführungsform werden als monomere Vorstufen 3,4-Alkylendioxythiophene der Formel (IIaa) 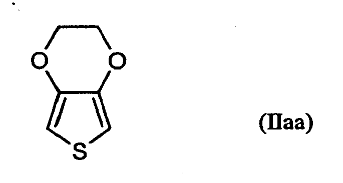 eingesetzt.

Unter Derivaten dieser monomeren Vorstufen werden im Sinne der Erfindung beispielsweise Dimere oder Trimere dieser monomeren Vorstufen verstanden. Es sind auch höhermolekulare Derivate, d.h. Tetramere, Pentamere etc. der monomeren Vorstufen als Derivate möglich. Die Derivate können sowohl aus gleichen wie unterschiedlichen Monomereinheiten aufgebaut sein und in reiner Form sowie im Gemisch untereinander und/oder mit den monomeren Vorstufen eingesetzt werden. Auch oxidierte oder reduzierte Formen dieser Vorstufen sind im Sinne der Erfindung von dem Begriff "Vorstufen" umfasst, sofern bei ihrer Polymerisation die gleichen leitfähigen Polymeren entstehen wie bei den vorangehend aufgeführten Vorstufen.

Als Substituenten für die Vorstufen, insbesondere für die Thiophene, bevorzugt für die 3,4-Alkylendioxythiophene kommen die für die allgemeine Formel (I) für R genannten Reste in Frage.

Verfahren zur Herstellung der monomeren Vorstufen für die Herstellung leitfähiger Polymere sowie deren Derivaten sind dem Fachmann bekannt und beispielsweise in L. Groenendaal, F. Jonas, D. Freitag, H. Pielartzik & J. R. Reynolds, Adv. Mater. 12 (2000) 481 - 494 und darin zitierter Literatur beschrieben.

Die Vorstufen können gegebenenfalls in Form von Lösungen eingesetzt werden. Als geeignete Lösungsmittel für die Vorstufen seien vor allem folgende unter den Reaktionsbedingungen inerte organische Lösungsmittel genannt: aliphatische Alkohole wie Methanol, Ethanol, i-Propanol und Butanol; aliphatische Ketone wie Aceton und Methylethylketon; aliphatische Carbonsäureester wie Essigsäureethylester und Essigsäurebutylester; aromatische Kohlenwasserstoffe wie Toluol und Xylol; aliphatische Kohlenwasserstoffe wie Hexan, Heptan und Cyclohexan; Chlorkohlenwasserstoffe wie Dichlormethan und Dichlorethan; aliphatische Nitrile wie Acetonitril, aliphatische Sulfoxide und Sulfone wie Dimethylsulfoxid und Sulfolan; aliphatische Carbonsäureamide wie Methylacetamid, Dimethylacetamid und Dimethylformamid; aliphatische und araliphatische Ether wie Diethylether und Anisol. Weiterhin kann auch Wasser oder ein Gemisch aus Wasser mit den vorgenannten organischen Lösungsmitteln als Lösungsmittel verwendet werden.

Den Lösungen können außerdem weitere Komponenten wie ein oder mehrere in organischen Lösungsmitteln lösliche organische Binder wie Polyvinylacetat, Polycarbonat, Polyvinylbutyral, Polyacrylsäureester, Polymethacrylsäureester, Polystyrol, Polyacrylnitril, Polyvinylchlorid, Polybutadien, Polyisopren, Polyether, Polyester, Silicone, Styrol/Acrylsäureester-, Vinylacetat/Acrylsäureester- und Ethylen/Vinylacetat-Copolymerisate oder wasserlösliche Binder wie Polyvinylalkohole, Vernetzer wie Polyurethane bzw. Polyurethandispersionen, Polyacrylate, Polyolefindispersionen, Epoxysilane, wie 3-Glycidoxypropyltrialkoxysilan, und/oder Additive wie z.B. Imidazol oder oberflächenaktive Stoffe zugesetzt werden. Weiterhin können Alkoxysilanhydrolysate, z.B. auf Basis von Tetraethoxysilan, zur Erhöhung der Kratzfestigkeit bei Beschichtungen zugesetzt werden.

Für den Fall, dass die Vorstufen chemisch oxidativ zu den leitfähigen Polymeren polymerisiert werden, ist die Anwesenheit eines oder mehrerer Oxidationsmittel erforderlich.

Als Oxidationsmittel können alle dem Fachmann bekannten für die oxidative Polymerisation von Thiophenen, Anilinen oder Pyrrolen geeignete Metallsalze verwendet werden.

Geeignete Metallsalze sind Metallsalze von Haupt- oder Nebengruppenmetallen, letztere im Folgenden auch als Übergangsmetallsalze bezeichnet, des Periodensystems der Elemente. Geeignete Übergangsmetallsalze sind insbesondere Salze einer anorganischen oder organischen Säure oder organische Reste aufweisenden anorganischen Säure von Übergangsmetallen, wie z.B. von Eisen(III), Kupfer(II), Chrom(VI), Cer(IV), Mangan(IV), Mangan(VII) und Ruthenium(III).

Bevorzugte Übergangsmetallsalze sind solche des Eisen(III). Eisen(III)-Salze sind häufig preiswert, leicht erhältlich und können leicht gehandhabt werden, wie z.B. die Eisen(III)-Salze anorganischer Säuren, wie beispielsweise Eisen(III)halogenide (z.B. FeCl₃) oder Eisen(III)-Salze anderer anorganischer Säuren, wie Fe(ClO₄)₃ oder Fe₂(SO₄)₃, und die Eisen(III)-Salze organischer Säuren und organische Reste aufweisender anorganischer Säuren.

Als Eisen(III)-Salze organische Reste aufweisender anorganischer Säuren seien beispielsweise die Eisen(III)-Salze der Schwefelsäuremonoester von C₁-C₂₀-Alkanolen, z.B. das Eisen(III)-Salz des Laurylsulfates genannt.

Besonders bevorzugte Übergangsmetallsalze sind solche einer organischen Säure, insbesondere Eisen(III)-Salze organischer Säuren.

Als Eisen(III)-Salze organischer Säuren seien beispielsweise genannt: die Eisen(III)-Salze von C₁-C₂₀-Alkansulfonsäuren, wie der Methan-, Ethan-, Propan-, Butan- oder höherer Sulfonsäuren wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen C₁-C₂₀-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch C₁-C₂₀-Alkylgruppen substituierten Sulfonsäuren wie der Benzolsulfonsäure, o-Toluolsulfonsäure, p-Toluolsulfonsäure oder der Dodecylbenzolsulfonsäure und von Cycloalkansulfonsäuren wie Camphersulfonsäure.

Es können auch beliebige Gemische dieser vorgenannten Eisen(III)-Salze organischer Säuren eingesetzt werden.

Die Verwendung der Eisen(III)-salze organischer Säuren und der organischen Reste aufweisenden anorganischen Säuren hat den großen Vorteil, dass sie nicht korrosiv wirken.

Ganz besonders bevorzugt als Metallsalze sind Eisen(III)-p-toluolsulfonat, Eisen(III)-o-toluolsulfonat oder einer Mischung aus Eisen(III)-p-toluolsulfonat und Eisen(III)-o-toluolsulfonat.

In bevorzugten Ausführungsformen sind die Metallsalze vor ihrem Einsatz mit einem Ionenaustauscher, vorzugsweise einem basischen Anionenaustauscher, behandelt worden. Beispiele für geeignete Ionenaustauscher sind mit tertiären Aminen funktionalisierte makroporöse Polymerisate aus Styrol und Divinylbenzol wie sie z.B. unter dem Handelnamen Lewatit® von der Bayer AG, Leverkusen vertrieben werden.

Weiterhin geeignete Oxidationsmittel sind Peroxoverbindungen wie Peroxodisulfate (Persulfate), insbesondere Ammonium- und Alkaliperoxodisulfate, wie Natrium- und Kaliumperoxodisulfat, oder Alkaliperborate - gegebenenfalls in Anwesenheit katalytischer Mengen an Metallionen, wie Eisen-, Cobalt-, Nickel-, Molybdän- oder Vanadiumionen - sowie Übergangsmetalloxide, wie z.B. Braunstein (Mangan(IV)oxid) oder Cer(IV)oxid.

Für die oxidative Polymerisation der Thiophene der Formel (II) werden theoretisch je Mol Thiophen 2,25 Äquivalente Oxidationsmittel benötigt (siehe z.B. J. Polym. Sc. Part A Polymer Chemistry Vol. 26, S. 1287 (1988)). Es können aber auch niedrigere oder höhere Äquivalente an Oxidationsmittel eingesetzt werden. Im Rahmen der Erfindung wird je Mol Thiophen bevorzugt ein Äquivalent oder mehr, besonders bevorzugt 2 Äquivalente oder mehr Oxidationsmittel eingesetzt.

Bevorzugt können die Anionen des verwendeten Oxidationsmittels als Gegenionen dienen, so dass im Falle der chemischen oxidativen Polymerisation eine Zugabe zusätzlicher Gegenionen nicht zwingend erforderlich ist.

Die Oxidationsmittel können gemeinsam mit oder getrennt von den Vorstufen - gegebenenfalls in Form von Lösungen - auf das Substrat aufgebracht werden. Bei getrennter Aufbringung von Vorstufen, Oxidationsmitteln und gegebenenfalls Gegenionen wird das Substrat vorzugsweise zunächst mit der Lösung des Oxidationsmittels und gegebenenfalls der Gegenionen und anschließend mit der Lösung der Vorstufen beschichtet. Bei der bevorzugten gemeinsamen Aufbringung von Thiophenen, Oxidationsmittel und gegebenenfalls Gegenionen wird die Oxidschicht des Anodenkörpers nur mit einer, nämlich einer Thiophene, Oxidationsmittel und gegebenenfalls Gegenionen enthaltenden Lösung beschichtet. Als Lösungsmittel kommen in allen Fällen die vorangehend als für die Vorstufen geeignet beschriebenen in Frage.

Die Lösungen können außerdem als weitere Komponenten die vorangehend bereits für die Lösungen der Vorstufen beschriebenen Komponenten (Binder, Vernetzer etc.) enthalten.

Die auf das Substrat aufzubringenden Lösungen enthalten vorzugsweise 1 bis 30 Gew.-% der Vorstufen, vorzugsweise der Thiophene der allgemeinen Formel (I) und gegebenenfalls 0 bis 50 Gew.- % Bindemittel, Vernetzer und/oder Additive, beide Gewichtsprozente bezogen auf das Gesamtgewicht der Mischung.

Die Lösungen werden nach bekannten Verfahren, z.B. durch Spincoating, Tränkung, Gießen, Auftropfen, Spritzen, Aufsprühen, Aufrakeln, Bestreichen oder Bedrucken, beispielsweise Ink-jet-, Sieb- oder Tampondrucken auf das Substrat aufgebracht.

Das Entfernen von gegebenenfalls vorhandenem Lösungsmittel nach dem Aufbringen der Lösungen kann durch einfaches Verdampfen bei Raumtemperatur erfolgen. Zur Erzielung höherer Verarbeitungsgeschwindigkeiten ist es jedoch vorteilhafter, die Lösungsmittel bei erhöhten Temperaturen, z.B. bei Temperaturen von 20 bis zu 300°C, bevorzugt 40 bis zu 250°C, zu entfernen. Eine thermische Nachbehandlung kann unmittelbar mit dem Entfernen des Lösungsmittel verbunden oder aber auch in zeitlichem Abstand von der Fertigstellung der Beschichtung vorgenommen werden. Die Lösungsmittel können vor, während oder nach der Polymerisation entfernt werden.

Die Dauer der Wärmebehandlung kann in Abhängigkeit von der Art des für die Beschichtung verwendeten Polymers 5 Sekunden bis mehrere Stunden betragen. Für die thermische Behandlung können auch Temperaturprofile mit unterschiedlichen Temperaturen und Verweilzeiten eingesetzt werden.

Die Wärmebehandlung kann z.B. in der Weise ausgeführt werden, dass man die beschichteten Substrate mit einer solchen Geschwindigkeit durch eine auf der gewünschten Temperatur befindliche Wärmekammer bewegt, dass die gewünschte Verweilzeit bei der gewählten Temperatur erreicht wird, oder mit einer auf der gewünschten Temperatur befindlichen Heizplatte für die gewünschte Verweilzeit in Kontakt bringt. Des Weiteren kann die Wärmebehandlung beispielsweise in einem Wärmeofen oder mehreren Wärmeöfen mit jeweils unterschiedlichen Temperaturen erfolgen.

Nach dem Entfernen der Lösungsmittel (Trocknen) und gegebenenfalls nach der thermischen Nachbehandlung kann es vorteilhaft sein, das überschüssige Oxidationsmittel und Restsalze aus der Schicht mit einem geeigneten Lösungsmittel, bevorzugt Wasser oder Alkoholen, auszuwaschen. Unter Restsalzen sind hier die Salze der reduzierten Form des Oxidationsmittels und gegebenenfalls weitere vorhandene Salze zu verstehen.

Die alternative elektrochemische Polymerisation kann nach dem Fachmann bekannten Verfahren durchgeführt werden.

Sofern die Monomere insbesondere die Thiophene der allgemeinen Formel (II) flüssig sind, kann die Elektropolymerisation in An- oder Abwesenheit von unter den Bedingungen der Elektropolymerisation inerten Lösungsmitteln vorgenommen werden; die Elektropolymerisation von festen monomeren insbesondere Thiophenen der allgemeinen Formel (II) wird in Gegenwart von unter den Bedingungen der elektrochemischen Polymerisation inerten Lösungsmitteln durchgeführt. In bestimmten Fällen kann es vorteilhaft sein, Lösungsmittelgemische einzusetzen und/oder den Lösungsmitteln Lösungsvermittler (Detergentien) zuzusetzen.

Als unter den Bedingungen der Elektropolymerisation inerte Lösungsmittel seien beispielsweise genannt: Wasser; Alkohole wie Methanol und Ethanol; Ketone wie Acetophenon; halogenierte Kohlenwasserstoffe wie Methylenchlorid, Chloroform, Tetrachlorkohlenstoff und Fluorkohlenwasserstoffe; Ester wie Ethylacetat und Butylacetat; Kohlensäureester wie Propylencarbonat; aromatische Kohlenwasserstoffe wie Benzol, Toluol, Xylol; aliphatische Kohlenwasserstoffe wie Pentan, Hexan, Heptan und Cyclohexan; Nitrile wie Acetonitril und Benzonitril; Sulfoxide wie Dimethylsulfoxid; Sulfone wie Dimethylsulfon, Phenylmethylsulfon und Sulfolan; flüssige aliphatische Amide wie Methylacetamid, Dimethylacetamid, Dimethylformamid, Pyrrolidon, N-Methylpyrrolidon, N-Methylcaprolactam; aliphatische und gemischt aliphatisch-aromatische Ether wie Diethylether und Anisol; flüssige Harnstoffe wie Tetramethylharnstoff oder N,N-Dimethylimidazolidinon.

Für die Elektropolymerisation werden die Monomere insbesondere die Thiophene der allgemeinen Formel (II) bzw. deren Lösungen mit Elektrolytzusätzen versetzt. Als Elektrolytzusätze werden vorzugsweise freie Säuren oder übliche Leitsalze verwendet, die eine gewisse Löslichkeit in den verwendeten Lösungsmitteln aufweisen. Als Elektrolytzusätze haben sich z.B. bewährt: freie Säuren wie p-Toluolsulfonsäure, Methansulfonsäure, ferner Salze mit Alkansulfonat-, aromatischen Sulfonat-, Tetrafluoroborat-, Hexafluorophosphat-, Perchlorat-, Hexafluoroantimonat-, Hexafluoroarsenat- und Hexachloroantimonat-Anionen und Alkali-, Erdalkali- oder gegebenenfalls alkylierten Ammonium-, Phosphonium-, Sulfonium- und Oxonium-Kationen.

Die Konzentration der Monomeren insbesondere der Thiophene der allgemeinen Formel (II) können zwischen 0,01 und 100 Gew.-% (100 Gew.-% nur bei flüssigem Thiophen) liegen; bevorzugt beträgt die Konzentration 0,1 bis 20 Gew.-%, bezogen auf das Gesamtgewicht der Lösung.

Die Elektropolymerisation kann diskontinuierlich oder kontinuierlich durchgeführt werden.

Die Stromdichte für die Elektropolymerisation kann in weiten Grenzen schwanken; üblicherweise wird mit einer Stromdichte von 0,0001 bis 100 mA/cm², vorzugsweise 0,01 bis 40 mA/cm² gearbeitet. Bei diesen Stromdichten stellt sich eine Spannung von etwa 0,1 bis 50 V ein.

Als Gegenionen eignen sich die oben bereits aufgeführten. Bei der elektrochemischen Polymerisation können diese Gegenionen der Lösung oder den Thiophenen gegebenenfalls als Elektrolytzusätze oder Leitsalze zugegeben werden.

Die elektrochemische oxidative Polymerisation der Thiophene der allgemeinen Formel (II) kann bei einer Temperatur von -78°C bis zum Siedepunkt des gegebenfalls eingesetzten Lösungsmittels vorgenommen werden. Bevorzugt wird bei einer Temperatur von -78°C bis 250°C, besonders bevorzugt von -20°C bis 60°C elektrochemisch polymerisiert.

Die Reaktionszeiten betragen in Abhängigkeit vom verwendeten Thiophen, dem verwendeten Elektrolyten, der gewählten Temperatur und der angewendeten Stromdichte vorzugsweise 1 Minute bis 24 Stunden.

Bei der elektrochemischen Polymerisation kann das Substrat, welches in der Regel nicht leitfähig ist, zunächst, wie in Groenendaal et al. Adv.Mat. 2003, 15, 855 beschrieben, mit einer dünnen transparenten Schicht eines leitfähigen Polymers beschichtet werden. Das so leitfähig beschichtete Substrat mit einem Oberflächenwiderstand von ≥ 10⁴ Ω/sq übernimmt bei der anschließenden Elektropolymerisation die Funktion der Pt-Elektrode. Die Schicht enthaltend das leitfähige Polymer wächst beim Anlegen einer Spannung darauf auf.

Da das oder die leitfähige(n) Polymer(e) in der Schicht enthaltend wenigstens ein leitfähiges Polymer direkt durch Polymerisation von Vorstufen in-situ auf dem Substrat erzeugt werden kann, wird diese Schicht im Folgenden auch als "in-situ-Schicht" bezeichnet. Der Begriff der in-situ-Abscheidung eines leitfähigen Polymers aus einer polymerisierbaren Lösung von Monomer und Oxidationsmittel ist in Fachkreisen allgemein bekannt.

Auf die in-situ-Schicht wird anschließend eine Schicht enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) aus einer Dispersion enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) aufgebracht.

Bevorzugt wird auf die in-situ-Schicht eine Schicht enthaltend wenigstens ein polymeres Anion und wenigstens ein Polythiophen mit wiederkehrenden Einheiten der allgemeinen Formel (I) aus einer Dispersion enthaltend wenigstens ein polymeres Anion und wenigstens ein Polythiophen mit wiederkehrenden Einheiten der allgemeinen Formel (I) aufgebracht.

Die Dispersionen können außerdem ein oder mehrere Lösungsmittel enthalten. Als Lösungsmittel kommen die vorangehend bereits für die Vorstufen genannten in Frage. Bevorzugte Lösungsmittel sind Wasser oder andere protische Lösungsmittel wie Alkohole, z.B. Methanol, Ethanol, i-Propanol und Butanol, sowie Mischungen von Wasser mit diesen Alkoholen, besonders bevorzugtes Lösungsmittel ist Wasser.

Die Dispersion wird zur Bildung der zweiten Schicht verfestigt, insbesondere bei Lösungsmittelhaltigen Dispersionen durch Entfernen des Lösungsmittels oder durch oxidative Vernetzung, bevorzugt durch Aussetzen der Dispersionsschicht mit (Luft)-Sauerstoff.

Als polymere Anionen kommen die vorangehend bereits aufgeführten in Frage. Vorzugsbereiche gelten analog.

Für die Polythiophene mit wiederkehrenden Einheiten der allgemeinen Formel (I) gilt das vorangehend im Zusammenhang mit der transparenten Elektrode bereits aufgeführte. Vorzugsbereiche gelten in beliebiger Kombination analog.

Die Herstellung der Dispersionen erfolgt aus Thiophenen der allgemeinen Formel (II) beispielsweise analog zu den in EP-A 440 957 genannten Bedingungen. Als Oxidationsmittel, Lösungsmittel und polymere Anionen kommen die vorangehend bereits aufgeführten in Frage.

Auch eine Herstellung des Polythiophen/Polyanion-Komplexes und anschließende Dispergierung oder Redispergierung in einem oder mehreren Lösungsmittel(n) ist möglich.

Die Dispersionen werden nach bekannten Verfahren, z.B. durch Spincoating, Tränkung, Gießen, Auftropfen, Spritzen, Aufsprühen, Aufrakeln, Bestreichen oder Bedrucken, beispielsweise Ink-jet-, Sieb- oder Tampondrucken auf die in-situ-Schicht aufgebracht.

Auch an die Aufbringung der Schicht enthaltend wenigstens ein polymeres Anion und wenigstens ein Polythiophen mit wiederkehrenden Einheiten der allgemeinen Formel (I) können sich Trocknung und/oder Reinigung der Schicht durch Waschen - wie vorangehend bereits für die in-situ-Schicht beschrieben - anschließen.

Nach dem erfindungsgemäßen Verfahren ist eine transparente Elektrode herstellbar, ohne dass aufwendige und teure Aufdampf- oder Aufsputterverfahren notwendig sind. Dadurch wird unter anderem auch eine großflächige Anwendung des erfindungsgemäßen Verfahrens ermöglicht. Außerdem lassen sich sowohl in-situ-Schicht als auch die Polythiophen/Polyanion-Schicht bei niedrigen Temperaturen, vorzugsweise Raumtemperatur aufbringen. Das erfindungsgemäße Verfahren ist somit auch für die Aufbringung auf polymere, flexible Substrate geeignet, die in der Regel nur Niedertemperaturprozesse vertragen und den Temperaturen bei der ITO-Abscheidung nicht standhalten.

Die erfindungsgemäßen Elektroden eignen sich hervorragend als Elektroden in elektrischen und bevorzugt in elektrooptischen Aufbauten, insbesondere in organischen Leuchtdioden (OLED), organischen Solarzellen (OSC) Flüssigkristallanzeigen (LCD) und optischen Sensoren.

Elektrooptische Aufbauten enthalten in der Regel zwei Elektroden, wovon mindestens eine lichtdurchlässig ist, und dazwischen ein elektrooptisch aktives Schichtsystem. Im Fall von OLEDs handelt es sich bei dem elektrooptischen Aufbau um eine elektrolumineszierende Schichtanordnung, die im Folgenden auch kurz als elektrolumineszierende Anordnung oder EL-Anordnung bezeichnet wird.

Der einfachste Fall einer solchen EL-Anordnung besteht aus zwei Elektroden, von denen mindestens eine transparent ist, und einer elektrooptisch aktiven Schicht zwischen diesen beiden Elektroden. Zusätzlich können jedoch weitere funktionelle Schichten in einem solchen elektrolumineszierenden Schichtaufbau enthalten sein, wie z.B. ladungsinjizierende, ladungstransportierende oder ladungsblockierende Zwischenschichten. Solche Schichtaufbauten sind dem Fachmann bekannt und beispielsweise in (J.R.Sheats et al.,Science 273, (1996), 884) beschrieben. Eine Schicht kann auch mehrere Aufgaben übernehmen. Im vorangehend beschriebenen einfachsten Fall einer EL-Anordnung kann die elektrooptisch aktive, d.h. in der Regel lichtemittierende, Schicht die Funktionen der anderen Schichten übernehmen. Eine der beiden Elektroden oder beide Elektroden können auf ein geeignetes Substrat, d.h. einen geeigneten Träger, aufgebracht sein. Der Schichtaufbau wird dann entsprechend kontaktiert und gegebenenfalls umhüllt und/oder verkapselt.

Der Aufbau von Mehrschichtsystemen kann durch Aufdampfverfahren (engl.: "Chemical Vapour deposition", CVD), bei denen die Schichten sukzessive aus der Gasphase aufgebracht werden, oder durch Gießverfahren erfolgen. Die Aufdampfverfahren werden in Verbindung mit der Lochmaskentechnik zur Fabrikation von strukturierten LEDs benutzt, die als Emitter organische Moleküle benutzen. Gießverfahren sind aufgrund der höheren Prozessgeschwindigkeiten und der geringeren Menge an produziertem Ausschussmaterial und der damit verbundenen Kostenersparnis generell bevorzugt.

Die erfindungsgemäßen Elektroden lassen sich - wie bereits vorangehend beschrieben - vorteilhafterweise aus Lösung/Dispersion herstellen

Weiterer Gegenstand der vorliegenden Erfindung ist daher eine elektrolumineszierende Anordnung bestehend wenigstens aus zwei Elektroden, von denen mindestens eine Elektrode transparent ist, und einer elektro-optisch aktiven Schicht zwischen den Elektroden, dadurch gekennzeichnet, das sie eine erfindungsgemäße Elektrode als transparente Elektrode enthält.

Bevorzugte elektrolumineszierende Anordnungen sind solche, die eine auf ein geeignetes Substrat aufgebrachte erfindungsgemäße Elektrode, d.h. in-situ-Schicht und Schicht enthaltend wenigstens ein polymeres Anion und wenigstens ein Polythiophen der allgemeinen Formel (I) enthalten, eine Emitter-Schicht und eine Metallkathode enthalten. Beispielsweise kann in einer solchen EL-Anordnung die Schicht enthaltend wenigstens ein polymeres Anion und wenigstens ein Polythiophen der allgemeinen Formel (I) als löcherinjizierende Zwischenschicht fungieren. Gegebenenfalls können weitere der vorangehend aufgeführten funktionellen Schichten enthalten sein.

Die elektrisch leitfähige Schicht wird insbesondere mit mehreren elektrisch hochleitfähigen metallischen Zuleitungen als Anode kontaktiert.

Eine bevorzugte Ausführungsform der vorliegenden Erfindung ist eine EL-Anordnung aus Schichten in folgender Reihenfolge:
Substrat // In-Situ-PEDT (Polyethylendioxythiophen)-Schicht // PEDT:PSS (Polyethylendioxythiophen/Polystyrolsulfonsäure) // Emitter-Schicht // Metallkathode.

Gegebenenfalls können weitere funktionelle Schichten enthalten sein.

Entsprechende Aufbauten mit erfindungsgemäßer Elektrode sind auch bei invertierten OLED- oder OSC-Aufbauten von Vorteil, d.h. wenn der Schicht-Aufbau in umgekehrter Reihenfolge erfolgt. Eine entsprechende bevorzugte Ausführungsform eines invertierten OLED's ist die folgende:
Substrat // Metallkathode // Emitter-Schicht // PEDT:PSS // In-Situ-PEDT.

Invertierte OLEDs sind insbesondere in Kombination mit Aktiv-Matrix Substraten von großem Interesse. Bei Aktiv-Matrix Substraten handelt es sich in der Regel um nicht-transparente Si-Schichten bei denen unter jedem Leuchtpixel ein Transistor prozessiert wurde.

Geeignete Emittermaterialien und Materialien für Metallkathoden sind die für elektrooptische Aufbauten gängigen und dem Fachmann bekannt. Als Metallkathode kommen bevorzugt solche aus Metallen mit geringer Austrittsarbeit wie Mg, Ca, Ba oder Metallsalzen wie LiF in Betracht. Als Emittermaterialien kommen bevorzugt konjugierte Polymere wie Polyphenylenvinylene oder Polyfluorene oder Emitter aus der Klasse der niedermolekularen Emitter, in Fachkreisen auch als "small molecules" bezeichnet, wie Tris(8-hydroxyquinolinato)aluminium (Alq₃) in Betracht.

Die erfindungsgemäße Elektrode hat in elektrooptischen Aufbauten gegenüber bekannten Elektroden eine Reihe von Vorteilen:
a) Auf TCO-Schichten, wie beispielsweise ITO, oder dünne Metallschichten kann z.B. in OLEDs und OSCs verzichtet werden
b) Im Fall von flexiblen Substraten kommt es bei Biegung des Substrats nicht zu Rissen in den spröden TCO-Schichten und einem Ausfall des elektrooptischen Aufbaus, da diese polymeren Schichten sehr duktil und flexibel sind.
c) Die etwas höhere Absorption der in-situ-Schicht bei höheren Schichtdicken hat den Vorteil, dass die Kontrastverhältnis zwischen erleuchteten und dunklen Bereichen bei Tageslicht deutlich verbessert wird. Ein Aufbringen einer Polarisationsfolie, die auch 50% des emittierten Lichts schlucken würde, kann damit entfallen.
d) Organische Schichten lassen sich einfacher strukturieren als anorganische wie z.B. ITO. Organische Schichten können mit Lösungsmitteln, durch optische Bestrahlung (UV) oder thermische Bestrahlung (Laser-Ablation) wieder entfernt werden.

Eine transparente Elektrode aus einer in-situ-Schicht alleine zeigt einen wesentlichen Nachteil für Anwendungen in OLEDs, da die erzielbaren Lichtausbeuten sehr niedrig sind. Überraschend führt das Aufbringen einer weiteren leitfähigen Schicht enthaltend polymere Anionen und Polythiophene mit wiederkehrenden Einheiten der allgemeinen Formel (I) zu deutlich höheren Lichtausbeuten. Diese Schicht kann sehr dünn sein und einen hohen spezifischen Widerstand haben, da der für die Lichtemission notwendige Devicestrom durch die darunter liegende in-situ-Schicht fließt. Als besonders geeignet haben sich die vorangehend bereits beschriebenen Schichten aus Poly(ethylendioxythiophen)/ Poly(styrolsulphonsäure) (PEDT:PSS) erwiesen.

Der gefundene Effekt ist unerwartet, da in beiden Schichten die einzige elektrisch aktive Komponente das elektrisch leitfähige Polymer bzw. insbesondere Polythiophen ist, wohingegen die polymeren Anionen elektrisch inert sind und vor allem dazu dienen, das elektrisch leitfähige Polymer bzw. Polythiophen bei der Polymerisation in Lösung zu halten.

Elektroden aus einer Polythiophen/Polyanion-Schicht, insbesondere aus einer PEDT:PSS-Schicht alleine sind im Gegensatz zur oben beschriebenen erfindungsgemäßen Doppelschicht aufgrund der zu niedrigen Leitfähigkeit oder der zu groben Teilchenstruktur für Anwendungen in OLEDs oder OSCs ebenfalls schlecht geeignet. Für solche Anwendungen geeignete PEDT:PSS-Formulierungen haben eine Zusammensetzung von PEDT:PSS wie 1:6 bzw. 1:20 und zeichnen sich durch sehr feine Teilchenstruktur aus. Der Oberflächenwiderstand einer 100 nm dicken Schicht aus diesen

Formulierungen beträgt jedoch 50 MΩ/sq bzw. 10 GΩ/sq. Damit sind diese Schichten alleine als Ersatz für ITO-Elektroden mit 10-50 Ω/sq aufgrund des zu hohen Oberflächenwiderstands ungeeignet. Die elektrische Leitfähigkeit von PEDT:PSS-Formulierung mit höherem PEDT-Gehalt, wie z.B. mit PEDT:PSS von 1:2,5 , lässt sich durch Zugabe von Additiven wie beispielsweise N-Methyl-Pyrrolidon, Sorbitol oder Glycerol zwar erhöhen, so dass Oberflächenwiderstände von ca. 10 kΩ/sq bei einer Schichtdicke von 100 nm erreicht werden, jedoch lassen sich selbst mit diesen leitfähigeren PEDT:PSS-Formulierungen alleine nicht die in der erfindungsgemäßen Doppelschicht erreichbaren Oberflächenwiderstände von kleiner 1000 Ω/sq bei 100 nm Schichtdicke realisieren. Nachteilig bei den Formulierungen mit höherem PEDT-Gehalt ist darüber hinaus die grobe Teilchenstruktur und die damit verbundene höhere Kurzschlusswahrscheinlichkeit für OLEDs und OSCs.

Eine spezielle erfindungsgemäße Elektrode mit einer 100 nm dicken in-situ-PEDT-Schicht und einer darüber liegenden PEDT:PSS-Schicht (PEDT:PSS-Verhältnis wie im vorangehenden Abschnitt) weist hingegen einen Oberflächenwiderstand von kleiner als 1000 Ω/sq auf. Zudem glättet die zusätzliche PEDT:PSS-Schicht die darunter liegende in-situ-PEDT-Schicht. Dies ist ein zusätzlicher Vorteil, weil dadurch die Wahrscheinlichkeit für Kurzschlüsse reduziert wird und sich damit die Ausbeute an funktionsfähigen OLEDs erhöht.

Des Weiteren wird durch die zusätzliche Polythiophen/Polyanion-Schicht auf der in-situ-Schicht in der erfindungsgemäßen Elektrode die Effizienz des elektrooptischen Aufbaus deutlich verbessert.

Um den Spannungsabfall zwischen Anodenkontaktstelle und OLED-Anode besonders klein zu halten, können wie oben beschrieben hochleitfähige Zuführungen, beispielsweise aus Metallen, sogenannte "bus-bars" verwendet werden.

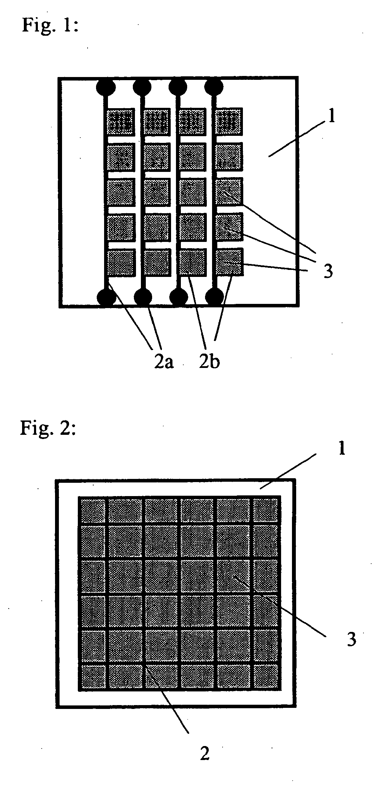

Im Fall von Passiv-Matrix-OLED-Displays kann aufgrund der Erfindung auf ITO-Adresslinien verzichtet werden. An deren Stelle übernehmen metallische Zuleitungen (bus-bars) in Kombination mit erfindungsgemäßer Elektrode die anodenseitige Adressierung (vgl. Fig.1). Auf einen transparenten Träger 1, z.B. eine Glasplatte, werden elektrische Zuleitungen 2a und Pixelrahmen 2b mit hoher Leitfähigkeit aufgebracht. Dies könnte z.B. durch Bedampfen von Metallen oder kostengünstig durch Bedrucken mit Metallpasten aufgebracht werden. In die Rahmen wird dann die polymere Elektrodenschicht 3 abgeschieden. Als erste Schicht wird gegebenenfalls ein Haftvermittler, als zweite Schicht die in-situ-Schicht und als dritte Schicht die Polythiophen(e) und polymere(s) Anion(en) enthaltende Schicht aufgebracht. Die Aufbringung dieser Schichten erfolgt bevorzugt durch Spin-coating, Drucken und ink-jetting. Der weitere Aufbau entspricht dem einer Standard Passiv-Matrix-OLED und ist dem Fachmann bekannt.

Im Fall homogen leuchtender OLEDs (OLED-Lampen) kann aufgrund der Erfindung auf ITO-Elektroden verzichtet werden. An deren Stelle übernehmen metallische Zuleitungen (bus-bars) in Kombination mit erfindungsgemäßer Elektrode die Funktion der ganzflächigen Anode (vgl. Fig.2). Auf einen transparenten Träger 1, z.B. eine Glasplatte, werden elektrische Zuleitungen 2 mit hoher Leitfähigkeit beispielsweise wie im vorangehenden Abschnitt beschrieben aufgebracht. Darauf wird dann in der wie im vorangehenden Abschnitt beschriebenen Reihenfolge die polymere Elektrodenschicht 3 abgeschieden. Der weitere Aufbau entspricht dem einer Standard OLED-Lampe.

### Beispiele

### Beispiel 1

### 1. Strukturierte Substrate:

ITO-beschichtete Glassubstrate (Merck Display) werden auf eine Größe von 50 x 50 mm² geschnitten und gereinigt. Danach wird die ITO-Beschichtung mit Photopositivlack (erhältlich bei der Fa. JSR, LCPR 1400G-80cP) beschichtet und dieser wird nach Trocknung durch eine bedruckte Polymerfolie (Schattenmaske) belichtet. Die Schattenmaske besteht aus isolierten lichtdurchlässigen Kreisen mit 5 mm Durchmesser, die quadratisch in einem Abstand von 10 mm angeordnet sind. Nach der Belichtung und Trocknung wird der unvernetzte Photolack aus den Kreisbereichen mit der Entwicklerlösung (erhältlich bei der Fa. JSR, TMA238WA) entfernt. An diesen nun unabgedeckten Stellen wird das ITO anschließend mit einer Ätzlösung, bestehend aus 47,5 Vol.-% entionisiertem (dest.) Wasser, 47,5 Vol.-% Salzsäure (32%ig ), 5,0 Vol.-% Salpetersäure (65%ig ), entfernt. Der vernetzte Photolack wird anschließend mit Aceton entfernt und das strukturierte ITO-Substrat wird abschließend gereinigt.

### 2. Herstellung der in-situ-PEDT-Schichten:

Epoxysilan (Silquest® A187, Fa. OSi specialities) wird mit 20 Teilen 2-Propanol verdünnt auf das gereinigte, strukturierte ITO-Substrat mit einem Spincoater aufgeschleudert und anschließend bei 50°C für 5 min an Luft getrocknet. Die Schichtdicke ist kleiner 20 nm. Eine Lösung bestehend aus Baytron® M , Baytron® CB 40 und Imidazol im Gew.-Verhältnis 1 : 20 : 0.5 wird angesetzt und filtriert (Millipore HV, 0,45 µm). Im Anschluss wird die Lösung mit einem Spincoater auf das mit Epoxysilan beschichtete strukturierte ITO-Substrat aufgeschleudert bei 1000 U/min. Anschließend wird die Schicht bei Raumtemperatur (RT, 23°C) getrocknet und danach mit dest. Wasser sorgfältig gespült, um die Eisensalze zu entfernen. Nach Trocknung der Schichten in einem Rotationstrockner beträgt die Schichtdicke ca. 150 nm. Die Oberflächenrauhigkeit Ra beträgt ca. 5 nm. Die Leitfähigkeit beträgt 550 S/cm.

### 3. Aufbringen der PEDT:PSS-Schicht:

Etwa 10 ml der 1,3 %igen Polyethylendioxythiophen/Polystyrolsulphonsäure wässrigen Lösung (Bayer AG, Baytron® P, TP AI 4083) werden filtriert (Millipore HV, 0,45 µm). Das Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 500). Die Oberflächenrauhigkeit Ra reduziert sich auf 1 nm.

Das Substrat mit den beiden nach Punkt 2. und 3. aufgebrachten Schichten weist eine Transmission von Y = 55 (ASTM D 1003-00; ASTM E 308) auf.

### 4. Aufbringen der Emitterschicht:

5 mL einer 1 Gew.-%igen Toluol-Lösung aus Poly(2-methoxy-5-(2'-ethyl-hexyloxy)-1,4-phenylenvinylen) (MEH-PPV, Fa. Aldrich, roter Emitter) werden filtriert (Millipore HV, 0,45µm) und auf der getrockneten PEDT:PSS-Schicht verteilt. Anschließend wird die überstehende Lösung durch Rotation des Tellers bei 300 U/min 30 sec lang abgeschleudert. Danach wird das so beschichtete Substrat 5 min lang bei 110°C auf einer Heizplatte getrocknet. Die Gesamtschichtdicke beträgt 150 nm.

### 5. Aufbringen der Metallkathoden:

Auf das organische Schichtsystem werden Metallelektroden gedampft. Die dafür eingesetzte Aufdampfanlage (Edwards) ist in einer Inertgas-Glovebox (Braun) integriert. Das Substrat wird mit der organischen Schicht nach unten auf eine Lochmaske gelegt. Die Löcher in der Maske haben einen Durchmesser von 2,5 mm und sind so angeordnet, dass sie a) zentrisch über den kreisrunden, abgeätzten ITO-Bereichen oder b) über der nichtabgeätzten ITO-Bereichen liegen. Aus zwei Aufdampfschiffchen werden bei einem Druck von p = 10-3 Pa nacheinander eine 30 nm dicke Ca-Schicht und anschließend eine 200 nm Ag-Schicht aufgedampft. Die Aufdampfraten betragen 10 Å/sec für Ca und 20 Å/sec für Ag.

### 6. Charakterisierung der OLEDs:

Aufgrund der strukturierten ITO-Substrate (Schritt 1) und der Positionierung der Bedampfungsmaske (Schritt 5) sind auf einem Substrat zwei verschiedene OLED-Aufbauten mit folgender vertikalen Schichtabfolge realisiert:
a) ITO//in-situ-PEDT//PEDT:PSS//Emitterschicht//Ca//Ag
b) in-situ-PEDT//PEDT:PSS//Emitterschicht//Ca//Ag

Zur elektrooptischen Charakterisierung werden die beiden Elektroden der OLED über elektrische Zuführungen mit einer Spannungsquelle verbunden. Der positive Pol ist mit der ganzflächigen ITO-Schicht, der negative Pol ist mit einer der aufgedampften Metall-Elektroden verbunden. Im Fall der OLED-Aufbauten auf abgeätztem ITO (vgl. b) dient das nicht abgeätzte ITO nur als niederohmige elektrische Zuführung für die in-situ-PEDT-Schicht.

Die Abhängigkeit des OLED-Stroms und der Elektrolumineszenzintensität (EL) von der Spannung werden aufgezeichnet. Der Nachweis der EL erfolgt mit einer Photodiode (EG&G C30809E) und die Kalibrierung der Leuchtdichte mit einem Luminanzmeter (Minolta LS-100).

### Beispiel 2

Durchführung wie im Beispiel 1, mit der Abweichung, dass Schritt 3 (Aufbringen der PEDT:PSS-Schicht) entfällt.

### Zusammenfassung der Ergebnisse aus Beispiel 1 und 2:

| OLED-Aufbau | Stromdichte [mA/cm²] | Spannung [V] | Leuchtdichte [cd/m²] | Effizienz [cd/A] |
|---|---|---|---|---|
| ITO//In-Situ-PEDT// PEDT:PSS//MEH-PPV//Ca//Ag (vgl. Beispiel 1) | 102 | 5.1 | 105 | 0.10 |
| In-Situ-PEDT//PEDT:PSS// MEHPPV//Ca//Ag (vgl. Beispiel 1) | 102 | 6.0 | 102 | 0.10 |
| ITO//In-Situ-PEDT// MEH-PPV//Ca//Ag (vgl. Beispiel 2) | 102 | 6.6 | 19 | 0.019 |
| In-Situ-PEDT//MEH-PPV//Ca//Ag (vgl. Beispiel 2) | 102 | 6.3 | 16 | 0.016 |

Damit ist gezeigt, dass OLEDs mit einer Leuchtfläche von mindestens 0,049 cm² bezüglich Leuchtdichte und Effizienz unabhängig davon sind, ob sich ITO unter der in-situ-PEDT-Schicht befindet oder nicht. Weiterhin wird durch den Vergleich von Beispiel 1 und 2 gezeigt, dass eine PEDT:PSS-Schicht zwischen der in-situ- und der MEH-PPV-Schicht (Emitterschicht) die Leuchtdichte signifikant verbessert.

### Beispiel 3

Durchführung wie im Beispiel 1, mit folgender Abweichung bei Schritt 4 (Aufbringen der Emitterschicht):

5 mL einer 0.25 Gew.%igen Chloroform-Lösung aus PF-F8 ((Poly(9,9-dioktylfluoren), blauer Emitter gemäß der Yamamoto-Polymerisationsmethode synthetisiert, die in der Literatur ausführlich beschrieben ist, z.B. T. Yamamoto et al., J. Am. Chem. Soc. 1996, 118, 10389-10399, bzw. T. Yamamoto et al., Macromolecules 1992, 25, 1214-1223.) werden filtriert (Millipore HV, 0,45µm) und auf der getrockneten PEDT:PSS-Schicht verteilt. Anschließend wird die überstehende Lösung durch Rotation des Tellers bei 200 U/min 30 sec lang abgeschleudert. Danach wird das so beschichtete Substrat 5 min lang bei 110°C auf einer Heizplatte getrocknet. Die Gesamtschichtdicke beträgt 130 nm.

### Beispiel 4

Durchführung wie im Beispiel 3, mit der Abweichung, dass Schritt 3 (Aufbringen der PEDT:PSSschicht) entfällt.

### Zusammenfassung der Ergebnisse aus Beispiel 3 und 4:

| OLED-Aufbau | Stromdichte [mA/cm²] | Spannung [V] | Leuchtdichte [cd/m²] | Effizienz [cd/A] |
|---|---|---|---|---|
| ITO//In-Situ-PEDT//PEDT:PSS// PFF8//Ca//Ag (vgl. Beispiel 3) | 204 | 6.9 | 28 | 0.014 |
| In-Situ-PEDT// PEDT:PSS//PF-F8// Ca//Ag (vgl. Beispiel 3) | 204 | 7.4 | 23 | 0.010 |
| ITO//In-Situ-PEDT//PF-F8//Ca//Ag (vgl. Beispiel 4) | 204 | 9.5 | 2,5 | 0.0012 |
| In-Situ-PEDT//PF-F8//Ca//Ag (vgl. Beispiel 4) | 204 | 9.3 | 2,3 | 0.0011 |

Damit ist gezeigt, dass OLEDs mit einer Leuchtfläche von mindestens 0,049 cm² bezüglich Leuchtdichte und Effizienz unabhängig davon sind, ob sich ITO unter der in-situ-PEDT-Schicht befindet oder nicht. Weiterhin wird durch den Vergleich von Beispiel 3 und 4 gezeigt, dass eine PEDT:PSS-Schicht zwischen der in-situ- und der PF-F8-Schicht (Emitterschicht) die Leuchtdichte signifikant erhöht und die Spannung erniedrigt.

Weiterhin fiel bei den Versuchen zu Beispiel 3 und 4 auf, dass die Anzahl der OLEDs pro Substrat ohne Kurzschluss mit einer PEDT:PSS Zwischenschicht signifikant höher war (ca. >80 %) als ohne (ca. <20%). Dies ist ein Beleg, dass PEDT:PSS-Schichten die In-Situ-Schicht glätten.

## Patentansprüche

1. Transparente Elektrode, **dadurch gekennzeichnet, dass** sie eine erste Schicht enthaltend wenigstens ein leitfähiges Polymer enthält, auf die eine zweite Schicht enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I), 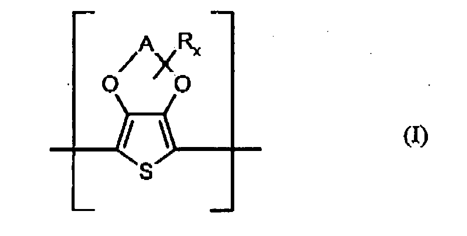 worin
A für einen gegebenenfalls substituierten C₁-C₅-Alkylenrest steht,
R für einen linearen oder verzweigten, gegebenenfalls substituierten C₁-C₁₈-Alkylrest, einen gegebenenfalls substituierten C₅-C₁₂-Cycloalkylrest einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können,
aufgebracht ist.

2. Elektrode gemäß Anspruch 1, **dadurch gekennzeichnet, dass** das leitfähige Polymer ein gegebenenfalls substituiertes Polythiophen, Polypyrrol oder Polyanilin ist.

3. Elektrode gemäß Anspruch 1 oder 2, **dadurch gekennzeichnet, dass** das leitfähige Polymer ein Polythiophen mit wiederkehrenden Einheiten der allgemeinen Formel (I) ist, wobei A, R und x die in Anspruch 1 angegebene Bedeutung tragen.

4. Elektrode gemäß wenigstens einem der Ansprüche 1 bis 3, **dadurch gekennzeichnet, dass** in Formel (I) für das leitfähige Polymer und das Polythiophen der zweiten Schicht unabhängig voneinander A für einen gegebenenfalls substituierten C₂-C₃-Alkylenrest und x für 0 oder 1 steht.

5. Elektrode gemäß wenigstens einem der Ansprüche 1 bis 4, **dadurch gekennzeichnet, dass** das Polythiophen mit wiederkehrenden Einheiten der allgemeinen Formel (I) für das leitfähige Polymer und das Polythiophen der zweiten Schicht unabhängig voneinander Poly(3,4-ethylendioxythiophen) ist.

6. Elektrode gemäß wenigstens einem der Ansprüche 1 bis 5, **dadurch gekennzeichnet, dass** das polymere Anion ein Anion einer polymeren Carbon- oder Sulfonsäure ist.

7. Elektrode gemäß wenigstens einem der Ansprüche 1 bis 6, **dadurch gekennzeichnet, dass** das polymere Anion ein Anion der Polystyrolsulfonsäure ist.

8. Elektrode gemäß wenigstens einem der Ansprüche 1 bis 7, **dadurch gekennzeichnet, dass** die beiden Schichten einen Oberflächenwiderstand von ≤ 1000 Ω/sq aufweisen.

9. Verfahren zur Herstellung einer transparenten Elektrode insbesondere gemäß wenigstens einem der Ansprüche 1 bis 8, **dadurch gekennzeichnet, dass**
eine erste Schicht enthaltend wenigstens ein leitfähiges Polymer hergestellt wird indem auf ein Substrat Vorstufen zur Herstellung leitfähiger Polymere gegebenenfalls in Form von Lösungen aufgebracht werden und chemisch oxidativ in Gegenwart eines oder mehrerer Oxidationsmittel oder elektrochemisch zu den leitfähigen Polymeren polymerisiert werden, und
auf diese Schicht gegebenenfalls nach Waschen und Trocknung eine zweite Schicht enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) 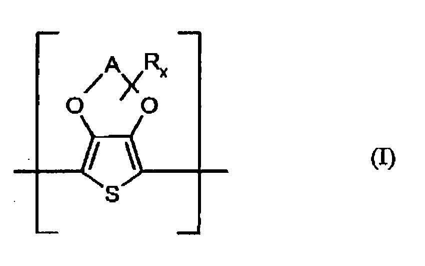 worin
A, R und x die in Anspruch 1 genannte Bedeutung haben,
und durch Aufbringen einer lösungsmittelhaltigen Dispersion enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) auf die elektrisch leitfähige Schicht und anschließendes Verfestigen der Dispersion gegebenenfalls durch Entfernen des Lösungsmittels oder Vernetzer der Dispersion aufgebracht wird.

10. Verfahren gemäß Anspruch 9, **dadurch gekennzeichnet, dass** das Substrat vor Aufbringen der Schicht enthaltend wenigstens ein leitfähiges Polymer mit einem Haftvermittler behandelt wird.

11. Verfahren gemäß Anspruch 9 oder 10, **dadurch gekennzeichnet, dass** als Vorstufen zur Herstellung leitfähiger Polymere gegebenenfalls substituierte Thiophene, Pyrrole oder Aniline eingesetzt werden.

12. Verfahren gemäß wenigstens einem der Ansprüche 9 bis 11, **dadurch gekennzeichnet, dass** als Vorstufen zur Herstellung leitfähiger Polymere Thiophene der allgemeinen Formel (II), 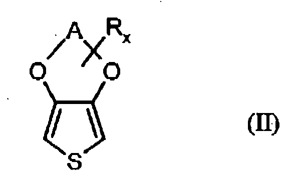 worin
A, R und x die in Anspruch 1 genannte Bedeutung haben, eingesetzt werden.

13. Verfahren gemäß wenigstens einem der Ansprüche 9 bis 12, **dadurch gekennzeichnet, dass** als Vorstufen zur Herstellung leitfähiger Polymere Thiophene der allgemeinen Formel (IIa), 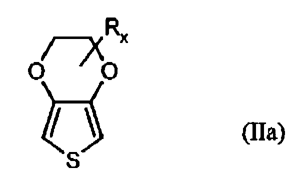 worin
R und x die in Anspruch 1 oder 4 genannte Bedeutung haben,
eingesetzt werden.

14. Verfahren gemäß wenigstens einem der Ansprüche 9 bis 13, **dadurch gekennzeichnet, dass** die Dispersion enthaltend wenigstens ein polymeres Anion und wenigstens ein gegebenenfalls substituiertes Polyanilin und/oder wenigstens ein Polythiophen mit wiederkehrenden Einheiten der allgemeinen Formel (I) als Lösungsmittel organische Lösungsmittel, Wasser oder Mischungen aus diesen enthalten.

15. Verfahren gemäß wenigstens einem der Ansprüche 9 bis 14, **dadurch gekennzeichnet, dass** die Vorstufen zur Herstellung leitfähiger Polymere chemisch oxidativ in Gegenwart eines oder mehrerer Oxidationsmittel zu den leitfähigen Polymeren polymerisiert werden.

16. Verwendung der Elektrode gemäß wenigstens einem der Ansprüche 1 bis 8 als transparente Elektrode in elektrooptischen Aufbauten.

17. Verwendung der Elektrode gemäß Anspruch 1 bis 8 als transparente Elektrode in organischen Leuchtdioden, organischen Solarzellen, Flüssigkristallanzeigen (LCD) und optischen Sensoren.

18. Elektrolumineszierende Anordnung bestehend wenigstens aus zwei Elektroden, von denen mindestens eine transparent ist, und einer elektrooptisch aktiven Schicht zwischen diesen Elektroden **dadurch gekennzeichnet, dass** sie als transparente Elektrode eine Elektrode gemäß wenigstens einem der Ansprüche 1 bis 8 enthält.

19. Elektrolumineszierende Anordnung gemäß Anspruch 18, **dadurch gekennzeichnet, dass** sie anodenseitig hochleitfähige metallische Zuleitungen enthält.

## Claims

1. Transparent electrode, **characterised in that** it comprises a first layer comprising at least one conductive polymer, on to which is applied a second layer comprising at least one polymeric anion and at least one optionally substituted polyaniline and/or at least one polythiophene having recurring units of the general formula (I) 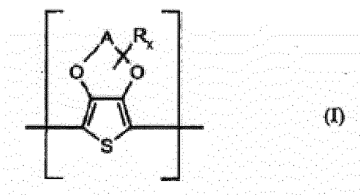 wherein
A represents an optionally substituted C₁-C₅-alkylene radical,
R represents a linear or branched, optionally substituted C₁-C₁₈-alkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxy radical,
x represents an integer from 0 to 8 and
in the case where several radicals R are bonded to A, these can be identical or different.

2. Electrode according to claim 1, **characterised in that** the conductive polymer is an optionally substituted polythiophene, polypyrrole or polyaniline.

3. Electrode according to claim 1 or 2, **characterised in that** the conductive polymer is a polythiophene having recurring units of the general formula (I), wherein A, R and x have the meaning given in claim 1.

4. Electrode according to at least one of claims 1 to 3, **characterised in that** in formula (I) for the conductive polymer and the polythiophene of the second layer independently of each other A represents an optionally substituted C₂-C₃-alkylene radical and x represents 0 or 1.

5. Electrode according to at least one of claims 1 to 4, **characterised in that** the polythiophene having recurring units of the general formula (I) for the conductive polymer and the polythiophene of the second layer independently of each other is poly(3,4-ethylenedioxythiophene).

6. Electrode according to at least one of claims 1 to 5, **characterised in that** the polymeric anion is an anion of a polymeric carboxylic or sulphonic acid.

7. Electrode according to at least one of claims 1 to 6, **characterised in that** the polymeric anion is an anion of polystyrenesulphonic acid.

8. Electrode according to at least one of claims 1 to 7, **characterised in that** the two layers have a surface resistance of ≤ 1,000 Ω/sq.

9. Method for producing a transparent electrode in particular according to at least one of claims 1 to 8, **characterised in that**
a first layer comprising at least one conductive polymer is produced by applying to a substrate precursors for the preparation of conductive polymers, optionally in the form of solutions, and polymerising them to the conductive polymers by chemical oxidation in the presence of one or more oxidising agents or electrochemically, and
to this layer, optionally after washing and drying, is applied a second layer comprising at least one polymeric anion and at least one optionally substituted polyaniline and/or at least one polythiophene having recurring units of the general formula (I) 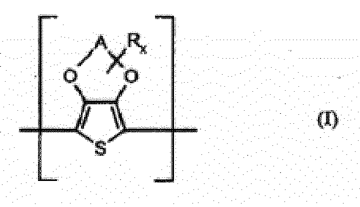 wherein
A, R and x have the meaning given in claim 1,
by application of a solvent-containing dispersion comprising at least one polymeric anion and at least one optionally substituted polyaniline and/or at least one polythiophene having recurring units of the general formula (I) to the electrically conductive layer and subsequent solidification of the dispersion, optionally by removal of the solvent or crosslinking agent of the dispersion.

10. Method according to claim 9, **characterised in that** the substrate is treated with an adhesion promoter before application of the layer comprising at least one conductive polymer.

11. Method according to claim 9 or 10, **characterised in that** optionally substituted thiophenes, pyrroles or anilines are employed as precursor for the preparation of conductive polymers.

12. Method according to at least one of claims 9 to 11, **characterised in that** thiophenes of the general formula (II) 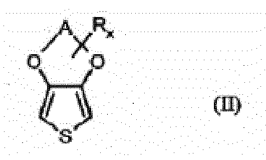 wherein
A, R and x have the meaning given in claim 1,
are employed as precursors for the preparation of conductive polymers.

13. Method according to at least one of claims 9 to 12, **characterised in that** thiophenes of the general formula (IIa) 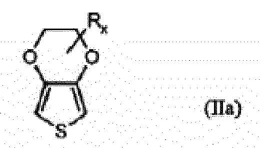 wherein
R and x have the meaning given in claim 1 or 4,
are employed as precursors for the preparation of conductive polymers.

14. Method according to at least one of claims 9 to 13, **characterised in that** the dispersion comprising at least one polymeric anion and at least one optionally substituted polyaniline and/or at least one polythiophene having recurring units of the general formula (I) comprises as solvents organic solvents, water or mixtures of these as the solvent.

15. Method according to at least one of claims 9 to 14, **characterised in that** the precursors for the preparation of conductive polymers are polymerised to the conductive polymers by chemical oxidation in the presence of one or more oxidising agents.

16. Use of the electrode according to at least one of claims 1 to 8 as a transparent electrode in optoelectronic devices.

17. Use of the electrode according to claim 1 to 8 as a transparent electrode in organic light-emitting diodes, organic solar cells, liquid crystal displays (LCD) and optical sensors.

18. Electroluminescent arrangement comprising at least two electrodes, at least one of which is transparent, and an optoelectronically active layer between these electrodes, **characterised in that** it comprises an electrode according to at least one of claims 1 to 8 as the transparent electrode.

19. Electroluminescent arrangement according to claim 18, **characterised in that** it comprises highly conductive metallic leads on the anode side.

## Revendications

1. Electrode transparente, **caractérisée en ce qu'**elle comprend une première couche contenant au moins un polymère conducteur, sur laquelle est déposée une deuxième couche contenant au moins un anion polymérique et au moins une polyaniline éventuellement substituée et/ou au moins un polythiophène ayant des motifs répétitifs de formule générale (I), 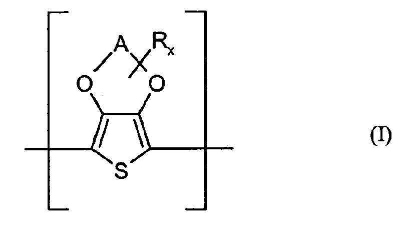 dans laquelle
A représente un radical alkylène en C₁ à C₅ éventuellement substitué,
R représente un radical alkyle en C₁ à C₁₈ linéaire ou ramifié, éventuellement substitué, un radical cycloalkyle en C₅ à C₁₂ éventuellement substitué, un radical aryle en C₆ à C₁₄ éventuellement substitué, un radical aralkyle en C₇ à C₁₈ éventuellement substitué, un radical hydroxyalkyle en C₁ à C₄ éventuellement substitué ou un radical hydroxyle,
x représente un nombre entier de 0 à 8 et
au cas où plusieurs radicaux R seraient liés à A, ceux-ci peuvent être identiques ou différents.

2. Electrode selon la revendication 1, **caractérisée en ce que** le polymère conducteur est un polythiophène, un polypyrrol ou une polyaniline, éventuellement substitué.

3. Electrode selon la revendication 1 ou 2, **caractérisée en ce que** le polymère conducteur est un polythiophène ayant des motifs répétitifs de formule générale (I), dans laquelle A, R et x ont la signification indiquée dans la revendication 1.

4. Electrode selon au moins l'une des revendications 1 à 3, **caractérisée en ce que**, dans la formule (I), pour le polymère conducteur et le polythiophène de la deuxième couche, A représente, indépendamment les uns des autres, un radical alkylène en C₂ à C₃ éventuellement substitué et x représente 0 ou 1.

5. Electrode selon au moins l'une des revendications 1 à 4, **caractérisée en ce que** le polythiophène ayant des motifs répétitifs de formule générale (I) est le polymère conducteur et le polythiophène de la deuxième couche est, indépendamment de l'autre, le poly(3,4-éthylènedioxythiophène).

6. Electrode selon au moins l'une des revendications 1 à 5, **caractérisée en ce que** l'anion polymérique est un anion d'un acide carboxylique ou sulfonique polymérique.

7. Electrode selon au moins l'une des revendications 1 à 6, **caractérisée en ce que** l'anion polymérique est un anion de l'acide polystyrènesulfonique.

8. Electrode selon au moins l'une des revendications 1 à 7, **caractérisée en ce que** les deux couches présentent une résistance superficielle de ≤ 1000 Ω/².

9. Procédé de fabrication d'une électrode transparente, en particulier selon au moins l'une des revendications 1 à 8, **caractérisé en ce que**
une première couche contenant au moins un polymère conducteur est produite en déposant des précurseurs pour la production des polymères conducteurs, éventuellement sous la forme de solutions, sur un substrat, et en la polymérisant par voie chimique oxydante en présence d'un ou de plusieurs agents oxydants ou par voie électrochimique pour donner des polymères conducteurs, et
sur cette couche, éventuellement par lavage et séchage, une deuxième couche contenant au moins un anion polymérique et au moins une polyaniline éventuellement substituée et/ou au moins un polythiophène ayant des motifs répétitifs de formule générale (I) 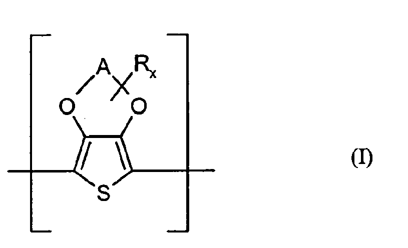 dans laquelle
A, R et x ont la signification indiquée dans la revendication 1,
et par dépôt d'une dispersion contenant des solvants, comprenant au moins un anion polymérique et au moins une polyaniline éventuellement substituée et/ou au moins un polythiophène ayant des motifs répétitifs de formule générale (I), sur la couche électriquement conductrice et par solidification consécutive de la dispersion, éventuellement par enlèvement du solvant ou des agents réticulants de la dispersion.

10. Procédé selon la revendication 9, **caractérisé en ce que** le substrat est traité avant dépôt de la couche contenant au moins un polymère conducteur avec un agent d'adhésion.

11. Procédé selon la revendication 9 ou 10, **caractérisé en ce que** des thiophènes, des pyrroles ou des anilines éventuellement substitués sont mis en oeuvre comme précurseurs pour la production des polymères conducteurs.

12. Procédé selon au moins l'une des revendications 9 à 11, **caractérisé en ce que** des thiophènes de formule générale (II), 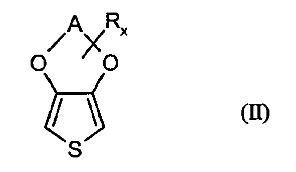 dans laquelle
A, R et x ont la signification indiquée dans la revendication 1, sont mis en oeuvre comme précurseurs pour la production des polymères conducteurs.

13. Procédé selon au moins l'une des revendications 9 à 12, **caractérisé en ce que** des thiophènes de formule générale (IIa), 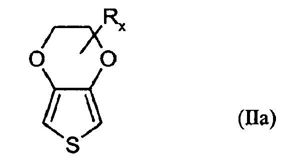 dans laquelle
R et x ont la signification indiquée dans la revendication 1 ou 4, sont mis en oeuvre comme précurseurs pour la production des polymères conducteurs.

14. Procédé selon au moins l'une des revendications 9 à 13, **caractérisé en ce que** la dispersion contenant au moins un anion polymérique et au moins une polyaniline éventuellement substituée et/ou au moins un polythiophène ayant des motifs répétitifs de formule générale (I) comprend des solvants organiques, de l'eau ou des mélanges de ceux-ci comme solvants.

15. Procédé selon au moins l'une des revendications 9 à 14, **caractérisé en ce que** les précurseurs pour la production des polymères conducteurs sont polymérisés par voie chimique oxydante en présence d'un ou de plusieurs agents oxydants pour donner des polymères conducteurs.

16. Utilisation de l'électrode selon au moins l'une des revendications 1 à 8 comme électrode transparente dans des structures électro-optiques.

17. Utilisation de l'électrode selon au moins l'une des revendications 1 à 8 comme électrode transparente dans des diodes organoluminescentes, des cellules photovoltaïques organiques, des affichages à cristaux liquides (LCD) et des capteurs optiques.

18. Dispositif électroluminescent constitué d'au moins deux électrodes, dont au moins une est transparente, et d'une couche électro-optiquement active entre ces électrodes, **caractérisé en ce qu'**il comprend comme électrode transparente une électrode selon au moins l'une des revendications 1 à 8.

19. Dispositif électroluminescent selon la revendication 18, **caractérisé en ce qu'**il comprend du côté anode des fils d'amenée métalliques hautement conducteurs.
